# EUROPEAN PATENT APPLICATION

(11) **EP 3 352 539 A1**
(43) Date of publication of application: **25.07.2018**
(21) Application number: 16845917.0
(22) Date of filing: 06.09.2016
(51) Int. Cl.: H05K 5/02

(54) **ELECTRIC DEVICE**

(30) Priority: 18.09.2015 JP 2015185737
(71) Applicant: Panasonic Intellectual Property Management Co., Ltd., Osaka-shi, Osaka 540-6207 (JP)
(72) Inventor: YOKOTA, Hirosi, Osaka-shi Osaka 540-6207 (JP)
(74) Representative: Appelt, Christian W.
(86) International application number: PCT/JP2016/004055
(87) International publication number: WO 2017/047042

(57) **Abstract**

An object of the present invention is to provide an electric device configured to reduce an exterior gap between constituent members of a housing. An electric device according to the present invention includes a case body (11) and a battery lid (16). A first wall portion (110) and a second wall portion (160) constitute a housing (1) with their respective tips butted against each other. The first wall portion (110) is made up of a sidewall (11d) and an elastic member (11b). The second wall portion (160) is made up of a peripheral wall (16d) and an elastic member (16b). A clearance (Y1) is provided between respective tips of the sidewall (11d) and the peripheral wall (16d) with respective tips of the elastic members (11b, 16b) butted against each other.

## Description

### Technical Field

The present invention relates to an electric device.

### Background Art

Some known electric devices have a housing configured as a combination of a plurality of members. For example, Patent Literature 1 discloses an exemplary electric device, of which the housing is configured as a combination of a first box-shaped member with one open side and a second box-shaped member with one open side.

However, it is difficult to form an electric device of this type with a completely flat appearance by bringing those constituent members of the housing into close contact with each other with no seams left at all. Such difficulty leaves a few choices, one of which is joining those members together with some gap left between those members, for example. This forms a seam as a gap between those constituent members on the exterior of the housing. Such a seam allows dust, dirt, and other foreign particles to enter the gap, and possibly the inside of the housing through the gap.

### Citation List

### Patent Literature

Patent Literature 1: JP 2013-171845 A

### Summary of Invention

It is therefore an object of the present invention to provide an electric device configured to reduce such an exterior gap between constituent members of a housing.

An electric device according to an aspect of the present invention includes: a first member including a first wall portion in a plate shape; and a second member including a second wall portion in a plate shape. The first wall portion and the second wall portion constitute a housing with their respective tips butted against each other. The first wall portion is made up of a first core member and a first elastic member provided on an outer surface of the first core member. The second wall portion is made up of a second core member and a second elastic member provided on an outer surface of the second core member. A clearance is provided between respective tips of the first core member and the second core member with respective tips of the first elastic member and the second elastic member butted against each other.

### Brief Description of Drawings

FIG. 1 is a cross-sectional view illustrating a principal portion of an electric device according to an embodiment;
FIG. 2 is a perspective view of the electric device illustrating a cross section of the principal portion thereof;
FIG. 3 is an exploded perspective view illustrating the configuration of the electric device;
FIG. 4 is a perspective view illustrating the appearance of the electric device as viewed from in front of the electric device;
FIG. 5 is a front view illustrating the configuration of the electric device;
FIG. 6 is a cross-sectional view taken along the plane X1-X2 and illustrating the configuration of the electric device;
FIG. 7 is a cross-sectional view taken along the plane X3-X4 and illustrating the configuration of the electric device;
FIG. 8 is an enlarged cross-sectional view illustrating the configuration of the electric device in the vicinity of a magnet unit thereof;
FIG. 9 schematically illustrates a seamless structure of the electric device;
FIG. 10 schematically illustrates a seamless structure of a first exemplary variation of the electric device;
FIG. 11A schematically illustrates a seamless structure of a second exemplary variation of the electric device;
FIG. 11B schematically illustrates a seamless structure of a third exemplary variation of the electric device;
FIG. 12A schematically illustrates a seamless structure of a fourth exemplary variation of the electric device;
FIG. 12B schematically illustrates a seamless structure of a fifth exemplary variation of the electric device;
FIG. 13 is a perspective view illustrating the appearance of a holding structure for the electric device as viewed from the front thereof; and
FIG. 14 is a perspective view illustrating the appearance of the holding structure for the electric device as viewed from the rear thereof.

### Description of Embodiments

Exemplary embodiments of the present disclosure generally relate to an electric device, and more particularly relate to an electric device, of which the housing is configured as a combination of a first member and a second member.

Embodiments of the present disclosure will now be described with reference to the accompanying drawings.

### (Embodiments)

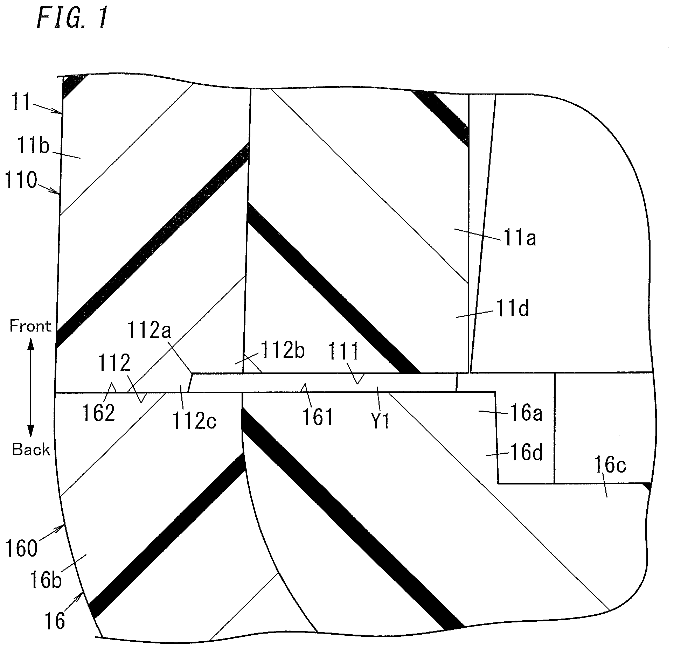

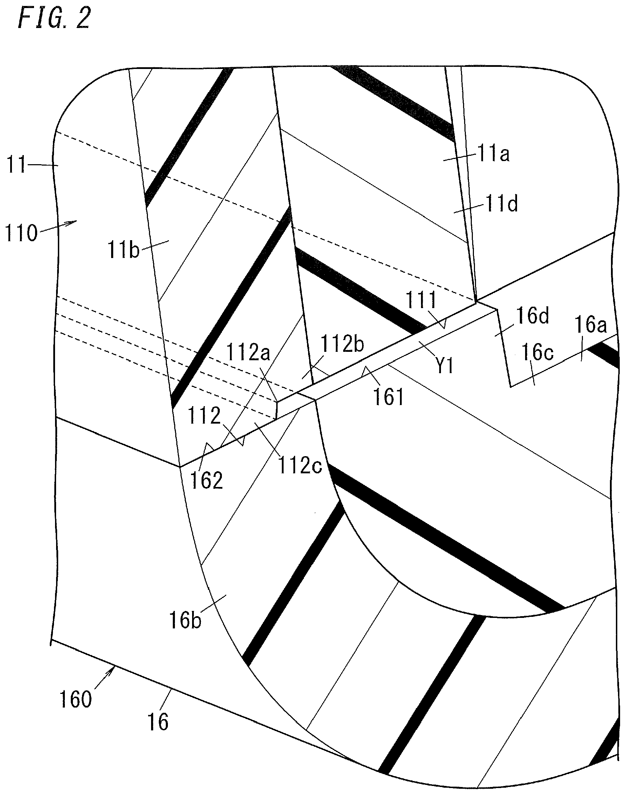

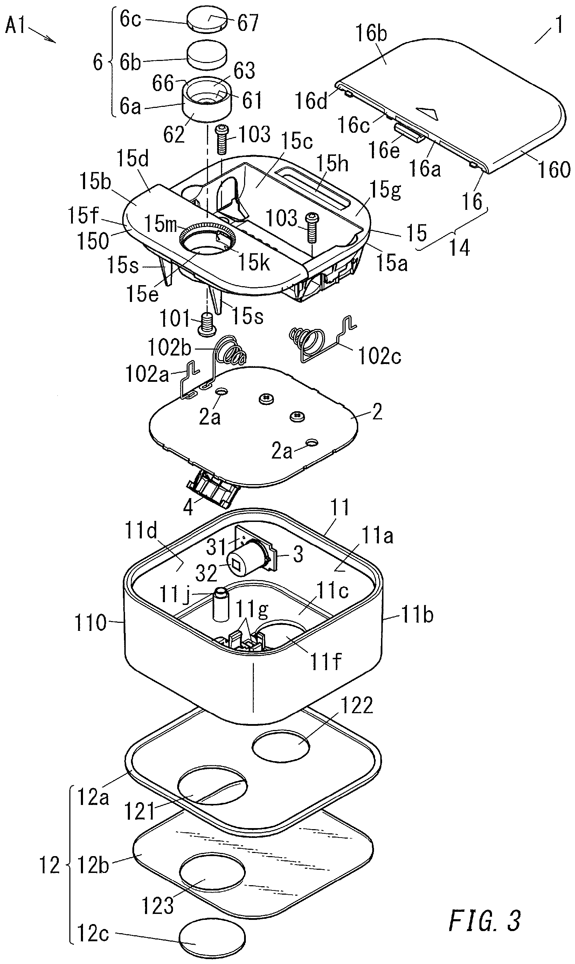

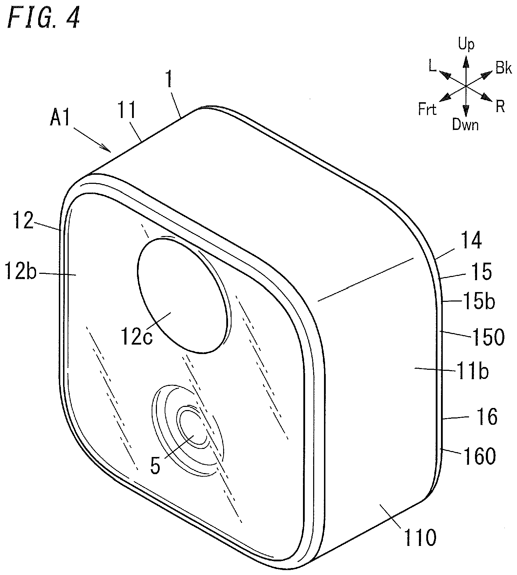

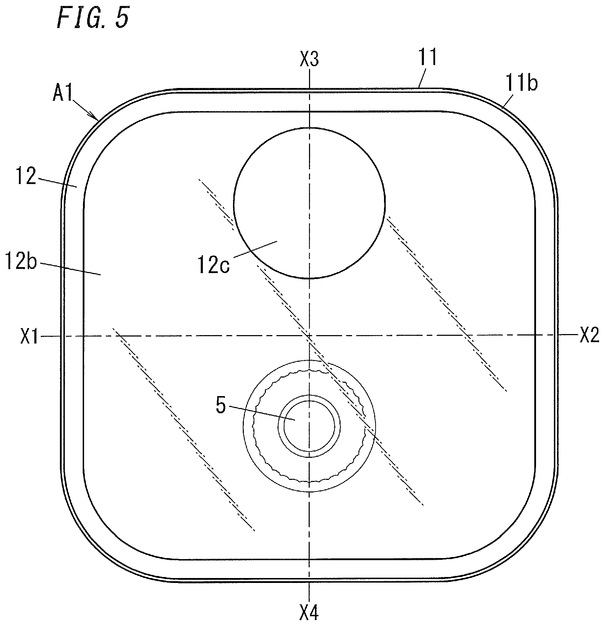

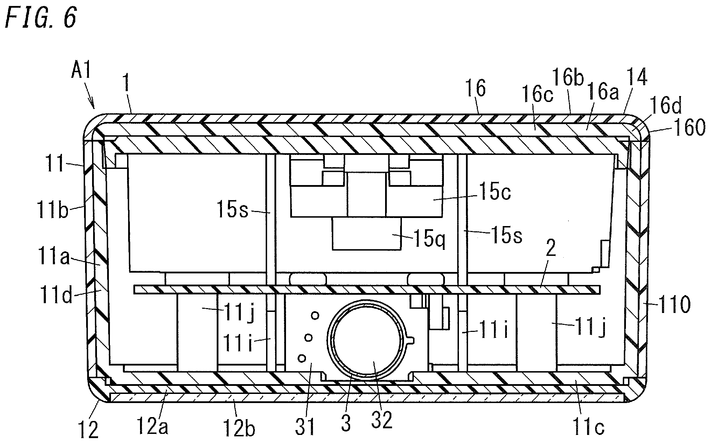

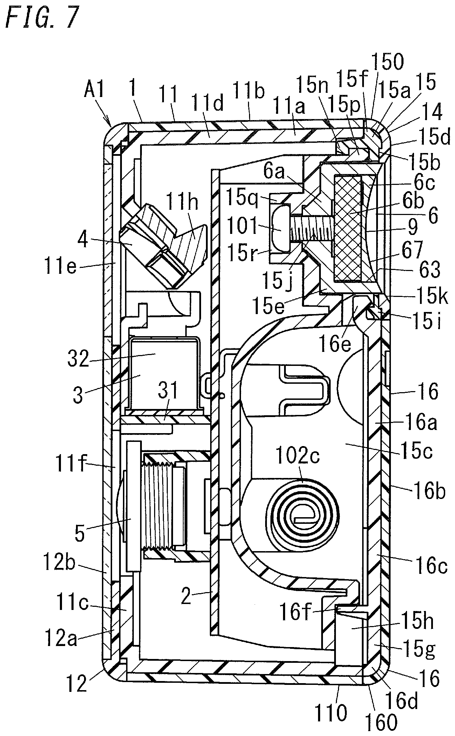

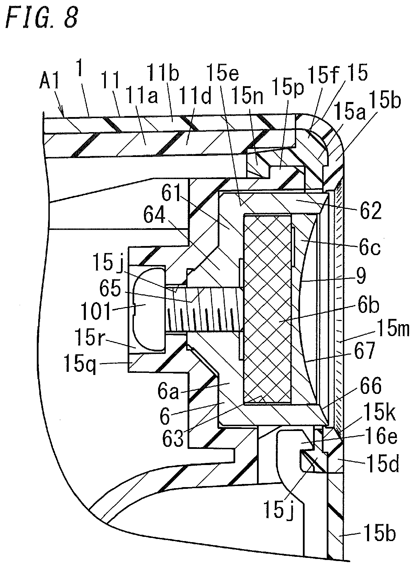

FIG. 1 is a cross-sectional view illustrating a principal portion of an electric device A1 according to an exemplary embodiment. FIG. 2 is a perspective view of the electric device A1 illustrating a cross section of the principal portion thereof. FIG. 3 is an exploded perspective view illustrating the configuration of the electric device A1. FIG. 4 is a perspective view illustrating the appearance of the electric device A1 as viewed from the front thereof. Note that in the following description, the upward, downward, rightward, leftward, forward, and backward directions are herein respectively defined by the up, down, right, left, front, and back arrows shown in FIG. 4. FIG. 5 is a front view of the electric device A1. FIG. 6 is a cross-sectional view thereof taken along the plane X1-X2 shown in FIG. 5 and viewed from under the electric device. FIG. 7 is a cross-sectional view thereof taken along the plane X3-X4 shown in FIG. 5 and viewed from the left of the electric device. FIG. 8 is a cross-sectional view illustrating the configuration of the electric device A1 in the vicinity of a magnet unit 6 thereof.

The electric device A1 of this embodiment includes a rectangular box-shaped housing 1, and a main board 2, a sensor unit 3, a mirror 4, and a magnet unit 6, all of which are housed in the housing 1. On the main board 2, assembled and integrated together are an image capturing unit 5, a controller, a wireless communication circuit, an antenna, and other components. The electric device A1 is designed to detect a human with the sensor unit 3, and perform image capturing processing with the image capturing unit 5 and transmit data of an image thus captured as a wireless signal. That is to say, the electric device A1 of this embodiment may operate as a wireless communication circuit, an image capture device, or a sensor device. The electric device A1 of this embodiment is driven by a battery as its power supply.

The housing 1 is configured as a combination of a case body 11, a front cover 12, and a rear cover 14.

The case body 11 has been formed by two-color molding. More specifically, in the case body 11, an outer surface of a core member 11a made of polycarbonate is partially covered with an elastic member 11b of a polyester-based elastomer. The core member 11a includes a rectangular front wall 11c and a sidewall 11d extended backward from an outer peripheral edge of the front wall 11c. The core member 11a is formed in the shape of a rectangular box with a rear opening. The outer surface of the sidewall 11d is covered with the elastic member 11b. That is to say, the peripheral edge of the rear opening of the case body 11 includes the rear end of the core member 11a inside and the rear end of the elastic member 11b outside.

The front wall 11c of the core member 11a has a circular hole 11e as an upper hole (see FIG. 7) and another circular hole 11f as a lower hole. The front cover 12 is attached onto the front wall 11c of the core member 11a.

The front cover 12 is made up of a cover body 12a, a light-transmitting cover 12b, and an infrared filter 12c. The cover body 12a is formed in a rectangular plate shape and attached to the front surface of the case body 11 with its rear surface brought face to face with the front wall 11c. The cover body 12a further has circular holes 121, 122 to respectively face the holes 11e, 11f of the core member 11a. The light-transmitting cover 12b has a light-transmitting property, has a circular hole 123 facing the hole 121, and is attached to the front surface of the cover body 12a. The infrared filter 12c in a disk shape is fitted into the hole 123. The infrared filter 12c may be made of polyethylene, for example, to transmit an incoming infrared ray, and transmits only incoming light falling within the infrared wavelength range.

The rear cover 14 is attached to the rear surface of the case body 11. The rear cover 14 is configured as a combination of a cover body 15 in the shape of a rectangular box, and a battery lid 16.

The cover body 15 has been formed by two-color molding. Specifically, in the cover body 15, the outer surface of its core member 15a of polycarbonate is partially covered with an elastic member 15b of a polyester-based elastomer. The core member 15a is formed in the shape of a rectangular box with a battery housing 15c, which is formed as a rectangular parallelepiped recess. Over the battery housing 15c, provided is a flat-plate extended portion 15d, which has a magnet housing 15e as a cylindrical recess. At the top of the extended portion 15d, an L-shaped latching piece 15n (see FIG. 7) is provided to protrude frontward. A latching claw 15p (see FIG. 7) provided on the outer peripheral edge of the magnet housing 15e is engaged with the latching piece 15n.

Furthermore, a curved peripheral wall 15f is extended forward from the top and right and left ends of the extended portion 15d. The rear surface of the extended portion 15d and the outer surface of the peripheral wall 15f are covered with the elastic member 15b. That is to say, the top, right and left peripheral edges of the extended portion 15d include the front end of the core member 15a inside and the front end of the elastic member 15b outside.

In addition, a flat-plate extended portion 15g is further provided under the battery housing 15c, and has a rectangular parallelepiped recess 15h.

The battery lid 16 has also been formed by two-color molding. Specifically, in the battery lid 16, the outer surface of its core member 16a of polycarbonate is partially covered with an elastic member 16b of a polyester-based elastomer. The core member 16a is formed in the shape of a rectangular plate with a rectangular rear wall 16c and a curved peripheral wall 16d extended forward from the bottom, right and left ends of the rear wall 16c. The rear surface of the rear wall 16c and the outer surface of the peripheral wall 16d are covered with the elastic member 16b. That is to say, the bottom, right, and left peripheral edges of the battery lid 16 include the front end of the core member 16a inside and the front end of the elastic member 16b outside.

The battery lid 16 is attached to the cover body 15 so as to close the battery housing 15c. Specifically, sliding the battery lid 16 upward from the bottom while bringing the battery lid 16 and the battery housing 15c face to face will have an L-shaped latching piece 16e, provided at the center of the top end of the battery lid 16, engaged with a latching claw 15i (see FIG. 7) provided at the bottom of the extended portion 15d, thus attaching the battery lid 16 to the cover body 15. In addition, a plate-shaped wall member 16f (see FIG. 7) is provided on the front surface of the rear wall 16c of the battery lid 16 so as to extend to the right and left. When the battery lid 16 is attached to the cover body 15, the wall member 16f is fitted into the recess 15h (see FIG. 7).

The latching piece 16e and the latching claw 15i may be disengaged from each other by pressing the battery lid 16 around a top center thereof with a finger, for example. Then, sliding the battery lid 16 downward allows the battery lid 16 to be removed from the cover body 15.

The battery housing 15c has a space to house a battery. At both longitudinal ends of the battery housing 15c, arranged are electrode springs 102a, 102b, and 102c to contact with the electrodes of the battery. The electric device A1 of this embodiment uses two size AA batteries. Alternatively, the batteries used may also be size D batteries, size C batteries, or size AAA batteries. Still alternatively, the electric device A1 of this embodiment may also be configured to use a single battery or three or more batteries.

In the magnet housing 15e of the cover body 15, housed is the magnet unit 6. The magnet unit 6 is made up of a yoke (magnet holder) 6a, a magnet 6b, and a magnet cap 6c. The yoke 6a is a cylindrical heel piece with a closed end surface, constituted of a circular bottom 61 and a peripheral wall 62 extended from the peripheral edge of the bottom 61, and has a cylindrical recess 63. The front surface of the bottom 61 has a boss 64 (see FIG. 8), the center of which has a screw hole 65 extending in the forward and backward directions (see FIG. 8). At the bottom of the recess 63, arranged is a disklike magnet 6b (such as a neodymium magnet), which is sandwiched between the bottom of the recess 63 and the disklike magnet cap 6c. The inside diameter of the recess 63 is slightly larger than outside diameter of the magnet 6b, and the front and side surfaces of the magnet 6b face, and are surrounded with, the yoke 6a. That is to say, the magnet 6b is totally surrounded with the yoke 6a except its rear surface. The magnet cap 6c is an elastic member made of a polyester-based elastomer, and is bonded and secured to the peripheral edge of the opening of the recess 63. On the rear end face of the magnet unit 6, the tip 66 of the peripheral wall 62 of the yoke 6a is exposed in an annular shape. The disklike magnet cap 6c is arranged inside the tip 66. The magnet cap 6c is provided only to protect the magnet 6b, and may be omitted if unnecessary.

A boss 15q (see FIG. 8) is provided for the front surface of the magnet housing 15e of the cover body 15, and has a recess 15r at the end face thereof. An insertion hole 15j is cut through the bottom of the recess 15r to extend in the axial direction of the boss 15q so that a screw 101 is inserted through the insertion hole 15j from the front and screwed into the screw hole 65 of the yoke 6a. Bringing the tip of the screw 101 into abutment with the front surface of the magnet 6b allows the magnet unit 6 to be secured inside the magnet housing 15e of the cover body 15 (see FIG. 8).

The opening edge 15k of the magnet housing 15e of the cover body 15 is covered with the elastic member 15b. The opening edge 15k is a curved surface, which is sloped forward so that the surface is curved toward the center of the magnet housing 15e. Likewise, the tip 66 of the peripheral wall 62 of the yoke 6a is also a curved surface, which is sloped forward so that the surface is curved toward the center of the recess 63. Furthermore, the magnet cap 6c has a curved rear surface 67. The opening edge 15k, the tip 66 of the peripheral wall 62, and the rear surface 67 of the magnet cap 6c (i.e., the surface exposed backward inside the magnet housing 15e) together form a recess 9, which is defined as a single continuous curved surface. The inner peripheral edge of the recess 9 defines the opening edge 15k. That is to say, the inner peripheral edge of the recess 9 is covered with the elastic member 15b.

Furthermore, inside the case body 11, housed are the main board 2, the sensor unit 3, and the mirror 4 (see FIGS. 3 and 7).

The sensor unit 3 is formed by mounting a human sensor 32 on a rectangular sensor substrate 31. The rear surface of the front wall 11c has a pair of clamping pieces 11g with elasticity (see FIG. 3). Clamping the human sensor 32 between the pair of clamping pieces 11g attaches the sensor unit 3 to the case body 11.

The human sensor 32 is a pyroelectric infrared sensor. The sensing plane of the human sensor 32 is arranged upward so as to face the bottom of the hole 11e. On the rear surface of the front wall 11c, a plate-shaped rib 11h with a sloped surface is arranged behind the hole 11e. The rib 11h vertically faces the sensing plane of the human sensor 32 and the mirror 4 is arranged on the sloped surface of the rib 11h. That is to say, the sensing plane of the human sensor 32 faces the mirror 4. An infrared ray, which has come in through the infrared filter 12c and the holes 121, 11e, is reflected by the mirror 4 and incident on the sensing plane of the human sensor 32. In response, the human sensor 32 outputs an electrical signal (sensing signal) representing the quantity of the incident infrared ray. The sensor substrate 31 is electrically connected to the main board 2 through a signal line. Then, the sensing signal generated by the human sensor 32 is input to a controller provided for the main board 2. If the controller has detected the presence of a human based on the sensing signal, image data captured by the image capturing unit 5 is transmitted as a wireless signal from the wireless communication circuit.

On the rear surface of the front wall 11c, arranged are a plurality of columnar ribs 11i (see FIG. 6). The main board 2 is arranged inside the case body 11 so that the front surface of the main board 2 abuts on the respective tips of the plurality of ribs 11i. The image capturing unit 5 is mounted on the front surface of the main board 2 and allowed to capture an image of the object in front through the holes 11f, 122 and the light-transmitting cover 12b.

In addition, a pair of columnar bosses 11j (see FIG. 6) are provided on the rear surface of the front wall 11c. The main board 2 has two holes 2a (see FIG. 3) at such positions as to face the respective tips of the bosses 11j. The tip end face of each of the bosses 11j has a screw hole extending in the axial direction. The bottom of the battery housing 15c of the cover body 15 has a pair of insertion holes. Inserting a pair of screws 103 from the rear into the pair of insertion holes and screwing those screws 103 into their respective screw holes of the bosses 11j through the pair of holes 2a of the main board 2 allows the cover body 15 to be attached to the case body 11.

Furthermore, on the front surface of the core member 15a of the cover body 15, provided are a plurality of columnar ribs 15s (see FIGS. 3 and 6). Attaching the cover body 15 to the rear surface of the case body 11 brings the rear surface of the main board 2 into abutment with the respective tips of the plurality of ribs 15s, thus having the main board 2 housed in the case body 11.

Then, the rear cover 14 (including the cover body 15 and the battery lid 16) is attached to the case body 11. In this case, the respective front ends of the elastic members 15b and 16b of the rear cover 14 are brought into abutment with the rear end of the elastic member 11b of the case body 11, thus flexing these elastic members 11b, 15, and 16b and bringing these elastic members 11b, 15, and 16b into close contact with each other. This makes the seams between the case body 11 and the rear cover 14 hardly perceptible at a glance, thus providing a so-called "seamless structure." Such a seamless structure will be described in further detail.

Note that the elastic member 11b has a higher elastic limit (i.e., has a greater degree of elasticity) than the core member 11a. Likewise, the elastic member 15b has a higher elastic limit than the core member 15a. The elastic member 16b has a higher elastic limit than the core member 16a. The material for the elastic members 11b, 15b, and 16b does not have to be the polyester-based elastomer. The material for the core members 11a, 15a, and 16a does not have to be polycarbonate, either.

FIGS. 1 and 2 are enlarged views illustrating portions of the case body 11 and battery lid 16 in the vicinity of the seams thereof. In this case, the case body 11 corresponds to the first member and the battery lid 16 corresponds to the second member. Also, the sidewall 11d of the case body 11 and the elastic member 11b provided on the sidewall 11d together form the first wall portion 110. In addition, the peripheral wall 16d of the battery lid 16 and the elastic member 16b provided on the peripheral wall 16d together form the second wall portion 160. The sidewall 11d corresponds to the first core member and the elastic member 11b corresponds to the first elastic member. Furthermore, the peripheral wall 16d corresponds to the second core member and the elastic member 16b corresponds to the second elastic member.

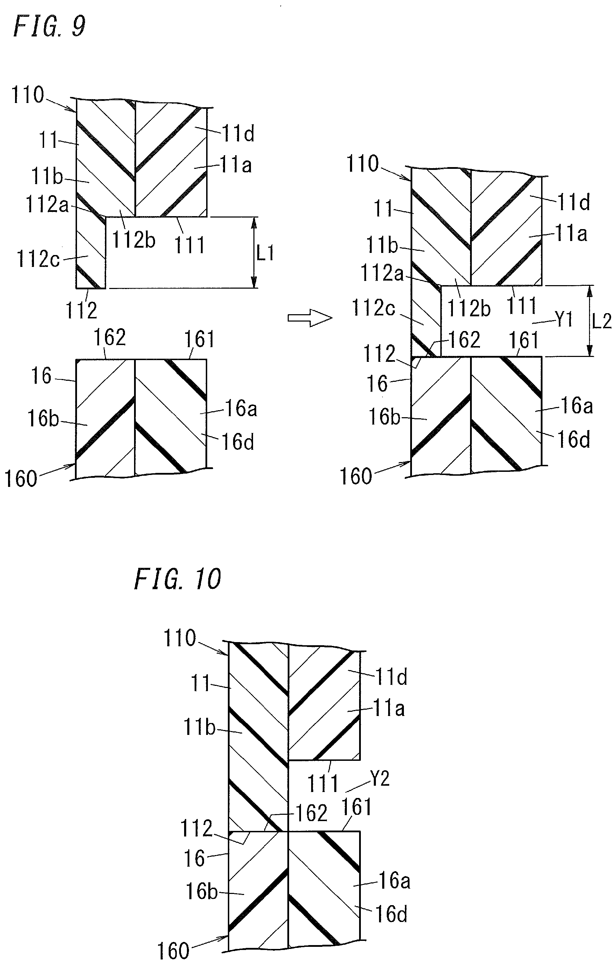

The rear end 112 of the elastic member 11b of the case body 11 has a stepped portion 112a (first stepped portion) so that an outer portion thereof protrudes backward with respect to an inner portion thereof. This forms a raised portion 112c protruding backward from a base end 112b. That is to say, the tip of the raised portion 112c defines the tip of the rear end 112. In this case, the length of the raised portion 112c as measured in the forward and backward directions will be designated by L1 (see FIG. 9).

In addition, in the forward and backward directions, the rear end (tip) 111 of the core member 11a of the case body 11 is located at the same position as the base end 112b. That is to say, the raised portion 112c protrudes backward with respect to the rear end 111 of the core member 11a.

Furthermore, in the forward and backward directions, the front end (tip) 162 of the elastic member 16b of the battery lid 16 is located at the same position as the front end (tip) 161 of the core member 16a.

Attaching the rear cover 14 to the rear surface of the case body 11 allows the front end 162 of the elastic member 16b to be butted against the raised portion 112c of the elastic member 11b. This flexes the elastic member 16b and the raised portion 112c of the elastic member 11b, thus bringing the front end 162 and the raised portion 112c into close contact with each other in the forward and backward directions. In this case, the rear end 112 of the elastic member 11b becomes more easily flexible locally, thus further reducing the exterior gap between the first wall portion 110 and the second wall portion 160.

In this case, the rear end 111 of the core member 11a and the front end 161 of the core member 16a face each other with a clearance Y1 left between them in the forward and backward directions. This reduces interference between the core member 11a and the core member 16a, thus facilitating the assembling process. Also, the length of the clearance Y1 as measured in the forward and backward directions is L2 (< L1), which is obtained by subtracting the amount of deflection of the elastic member 16b and the raised portion 112c from the length L1 of the raised portion 112c as measured in the forward and backward directions (see FIG. 9).

Thus, such close contact between the raised portion 112c of the elastic member 11b and the front end 162 of the elastic member 16b significantly reduces the exterior gap to be left along the seam between the case body 11 and the battery lid 16. That is to say, this electric device A1 reduces the exterior gap between the case body 11 and the battery lid 16, thus reducing the chances of allowing dust, dirt, and other foreign particles to be deposited on the gap and/or enter the inside of the housing 1. In addition, this also makes the exterior seam between the case body 11 and battery lid 16 much less perceptible to the eye, thus giving the viewer a sense of unity between the case body 11 and the battery lid 16 and significantly improving their aesthetic design.

A first variation is illustrated in FIG. 10, in which the rear end (tip) 112 of the elastic member 11b protrudes backward with respect to the rear end (tip) 111 of the core member 11a without being provided with the stepped portion 112a. In that case, the front end 162 of the elastic member 16b is butted against the rear end 112 of the elastic member 11b, thus flexing these elastic members 16b and 11b and bringing the front end 162 and the rear end 112 into close contact with each other in the forward and backward directions. In this case, the rear end 111 of the core member 11a and the front end 161 of the core member 16a face each other with a clearance Y2 left between them in the forward and backward directions.

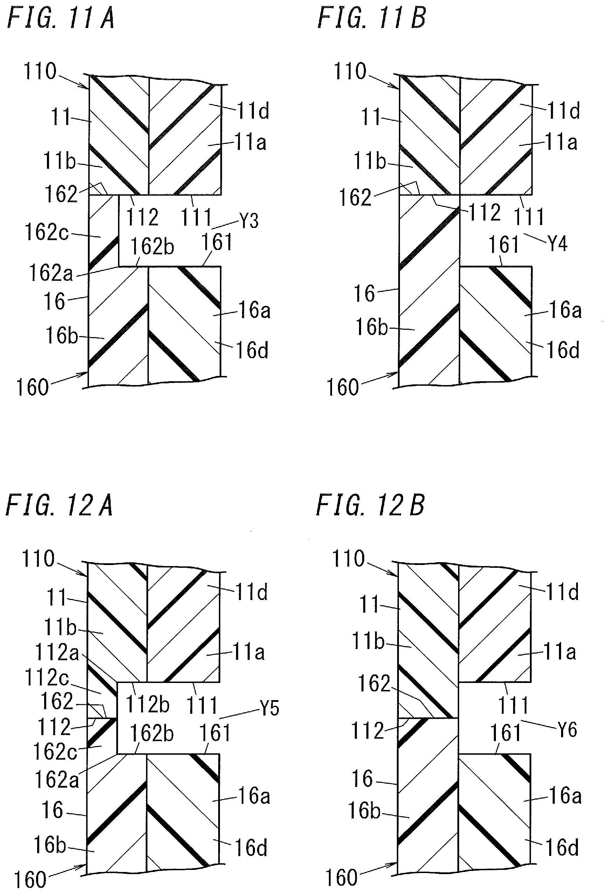

A second variation is illustrated in FIG. 11A, in which a stepped portion (second stepped portion) 162a is provided for the front end 162 of the elastic member 16b of the battery lid 16. The stepped portion 162a is formed such that an outer portion thereof protrudes forward with respect to an inner portion thereof, thus defining a raised portion 162c that protrudes forward with respect to a base end 162b thereof. That is to say, the tip of the raised portion 162c is the tip of the front end 162.

Also, in the forward and backward directions, the front end (tip) 161 of the core member 16a of the battery lid 16 is located at the same position as the base end 162b. That is to say, the raised portion 162c protrudes forward with respect to the front end 161 of the core member 16a.

Furthermore, in the forward and backward directions, the rear end (tip) of the elastic member 11b of the case body 11 is located at the same position as the rear end (tip) 111 of the core member 11a.

Attaching the battery lid 16 to the rear surface of the case body 11 allows the raised portion 162c of the elastic member 16b to be butted against the rear end 112 of the elastic member 11b. This flexes the raised portion 162c of the elastic member 16b and the elastic member 11b, thus bringing the raised portion 162c and the elastic member 11b into close contact with each other in the forward and backward directions. In this case, the front end 162 of the elastic member 16b becomes more easily flexible locally, thus further reducing the exterior gap between the first wall portion 110 and the second wall portion 160.

In this case, the rear end 111 of the core member 11a and the front end 161 of the core member 16a face each other with a clearance Y3 left between them in the forward and backward directions.

A third variation is illustrated in FIG. 11B, in which the front end (tip) 162 of the elastic member 16b protrudes forward with respect to the front end (tip) 161 of the core member 16a without being provided with the stepped portion 162a. In such a variation, the front end 162 of the elastic member 16b is butted against the rear end 112 of the elastic member 11b, thus flexing these elastic members 16b and 11b and bringing the front end 162 and the rear end 112 into close contact with each other in the forward and backward directions. In this case, the rear end 111 of the core member 11a and the front end 161 of the core member 16a face each other with a clearance Y4 left between them in the forward and backward directions.

A fourth variation is illustrated in FIG. 12A, in which both of the stepped portions 112a and 162a described above are provided. In that case, attaching the battery lid 16 to the rear surface of the case body 11 allows the raised portion 162c of the elastic member 16b to be butted against the raised portion 112c of the elastic member 11b. This flexes the raised portion 162c of the elastic member 16b and the raised portion 112c of the elastic member 11b, thus bringing these raised portions 162c and 112c into close contact with each other in the forward and backward directions.

In this case, the rear end 111 of the core member 11a and the front end 161 of the core member 16a face each other with a clearance Y5 left between them in the forward and backward directions.

A fifth variation is illustrated in FIG. 12B, in which neither the stepped portion 112a nor the stepped portion 162a is provided. In such a variation, the rear end (tip) 112 of the elastic member 11b protrudes backward with respect to the rear end (tip) 111 of the core member 11a, and the front end (tip) 162 of the elastic member 16b protrudes forward with respect to the front end (tip) 161 of the core member 16a. Then, the front end 162 of the elastic member 16b is butted against the rear end 112 of the elastic member 11b, thus flexing these elastic members 16b and 11b and bringing the front end 162 and the rear end 112 into close contact with each other in the forward and backward directions. In this case, the rear end 111 of the core member 11a and the front end 161 of the core member 16a face each other with a clearance Y6 left between them in the forward and backward directions.

Thus, according to any of the configurations of the first to fifth variations described above, such close contact between the elastic member 11b and the elastic member 16b significantly reduces the exterior gap to be left along the seam between the case body 11 and the battery lid 16. This reduces the chances of allowing dust, dirt, and other foreign particles to be deposited on the gap and/or enter the inside of the housing 1. In addition, this also makes the exterior seam between the case body 11 and battery lid 16 much less perceptible to the eye, thus giving the viewer a sense of unity between the case body 11 and the battery lid 16 and significantly improving their aesthetic design.

Alternatively, the case body 11 may be the first member and the cover body 15 may be the second member. Even so, the same advantages would also be achieved. In such an alternative embodiment, the peripheral wall 15f of the extended portion 15d of the cover body 15 and the elastic member 15b provided on the peripheral wall 15f together form the second wall portion 150 (see FIG. 3, 4, and 7). Also, the peripheral wall 15f corresponds to the second core member and the elastic member 15b corresponds to the second elastic member. In that case, the electric device A1 reduces the exterior gap between the case body 11 and the cover body 15.

Also, in this embodiment, the elastic member 11b is formed on the outer surface of the core member 11a by two-color molding. The elastic member 15b is formed on the outer surface of the core member 15a by two-color molding. The elastic member 16b is formed on the outer surface of the core member 16a by two-color molding. This allows the elastic members 11b, 15b, and 16b to absorb the deformation and strain of the core members 11a, 15a, and 16a, respectively, thus improving their appearance.

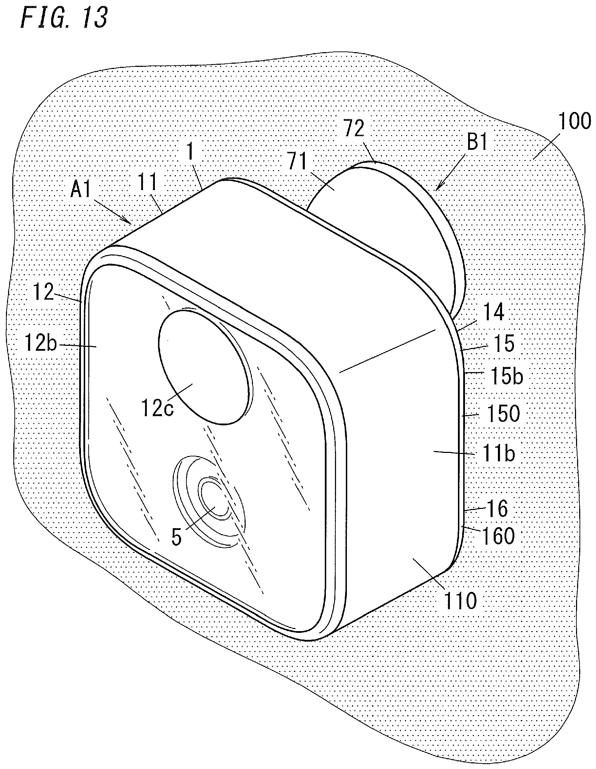

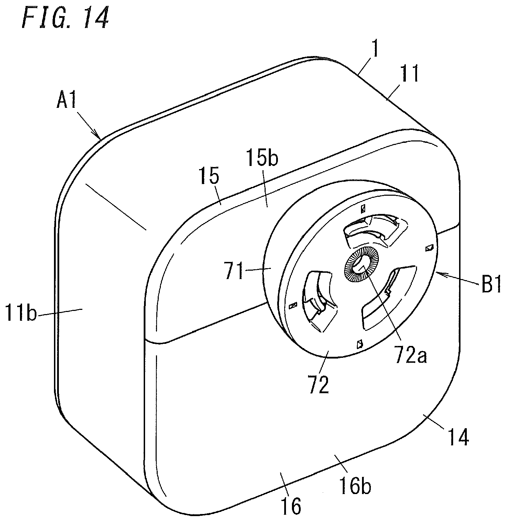

The electric device A1 of this embodiment is held by a holder B1 to be readily attachable and removable as shown in FIGS. 13 and 14. The holder B1 will be described in detail. The holder B1 is formed in a hollow hemispheric shape and includes a hemispheric connecting portion 71 and a disklike base 72.

The connecting portion 71 has a hemispheric cup shape and may be made of iron, for example. However, this is only an example and should not be construed as limiting. The connecting portion 71 only needs to be made of a material with magnetism (suitably, a ferromagnetic material), and therefore, may be made of a magnetic material other than iron. The base 72 has an insertion hole 72a, which is provided to be shifted from its center. Inserting a screw into the insertion hole 72a from the front and screwing the screw onto a structural surface 100 such as a wall surface secures the base 72 to the structural surface 100.

The connecting portion 71 is configured to be readily attachable to, and removable from, the base 72. That is to say, the connecting portion 71 and the base 72 have their respective latching portions that engage with each other. Then, the connecting portion 71, which is brought into abutment with the base 72 secured to the structural surface 100, may be rotated in a first direction (e.g., clockwise in this example). This brings the respective latching portions of the connecting portion 71 and the base 72 into engagement with each other, securing the connecting portion 71 to the base 72. Alternatively, rotating the connecting portion 71 in a second direction (e.g., counterclockwise in this case) may bring the connecting portion 71 and the base 72 out of engagement with each other, removing the connecting portion 71 from the base 72.

Next, a holding structure allowing the electric device A1 of this embodiment to be held by the holder B1 will be described. Suppose the base 72 has already been secured to the structural surface 100 and the connecting portion 71 has already been attached to the base 72 in this case.

When the recess 9 on the rear surface of the housing 1 of the electric device A1 is brought close to the connecting portion 71 of the holder B1, the magnetic force of the magnet unit 6 attracts the housing 1 toward the connecting portion 71 with magnetism, bringing the recess 9 into abutment with the connecting portion 71. From then on, the magnetic force of the magnet unit 6 will keep the housing 1 held onto the connecting portion 71 with magnetism. When the image capturing direction of the image capturing unit 5 of the electric device A1 or the sensing direction of the human sensor 32 needs to be changed, the user applies rotational force to the housing 1 with the housing 1 held by the holder B1. This makes the housing 1 rotate with the recess 9 kept in contact with the connecting portion 71, thus allowing the user to adjust the orientation of the housing 1 with respect to the structural surface 100.

Therefore, in the electric device A1 of this embodiment, the magnetic force keeps the housing 1 held by the holder B1, thus allowing the user to easily adjust the orientation of the housing 1 with respect to the structural surface 10 while saving him or her a lot of trouble.

Besides, the electric device A1 has the capability of transmitting the data of an image captured by the image capturing unit 5 as a wireless signal by operating with the power supplied from a battery housed in the battery housing 15c. Such an electric device A1 may be used to provide services of watching, or monitoring the behaviors of, seniors or children, for example. For this purpose, the holder B1 may be fixed on the wall of a senior's or a child's house or room, for example, the electric device A1 may be attached to the holder B1, and data of captured images may be transmitted to his or her family member's smartphone, cellphone, tablet computer, or personal computer, or a server managed by the watch service provider. This allows the family member or the watch service provider to monitor the behavior or wellness of the target senior or child.

The electric device A1 may be compliant with any wireless communication standard, which may be appropriately selected from wireless LAN (local area network), Bluetooth™, and other standards without particular limitation.

As can be seen from the foregoing description, an electric device A1 according to a first aspect of the exemplary embodiment includes: a first member (case body 11) including a first wall portion 110 in a plate shape; and a second member (cover body 15 or battery lid 16) including a second wall portion 150, 160 in a plate shape. The first wall portion 110 and the second wall portion 150, 160 constitute a housing 1 with their respective tips butted against each other. The first wall portion 110 is made up of a first core member (sidewall 11d) and a first elastic member (elastic member 11b) provided on an outer surface of the first core member. The second wall portion 150 or 160 is made up of a second core member (peripheral wall 15f or 16d) and a second elastic member (elastic member 15b, 16b) provided on an outer surface of the second core member. A clearance (Y1-Y6) is provided between respective tips of the first core member and the second core member with respective tips of the first elastic member and the second elastic member butted against each other.

This significantly reduces an exterior gap to be left along the seams between the case body 11, the cover body 15, and the battery lid 16, thus reducing the chances of allowing dust, dirt, and other foreign particles to be deposited on the gaps and/or enter the inside of the housing 1. In addition, this also makes the exterior seams between the case body 11, the cover body 15, and the battery lid 16 much less easily perceptible to the eye, thus giving the user a sense of unity between the case body 11, the cover body 15, and the battery lid 16 and significantly improving their aesthetic design. That is to say, this electric device A1 reduces the exterior gap between the constituent members of the housing 1 (i.e., between the case body 11, the cover body 15, and the battery lid 16).

In an electric device A1 according to a second aspect of the exemplary embodiment, which may be implemented in conjunction with the first aspect, the tip of the first elastic member may protrude with respect to the tip of the first core member.

This allows a clearance (Y1, Y2, Y5, Y6) to be left between the respective tips of the first core member and the second core member by specially designing the configuration of the first member.

In an electric device A1 according to a third aspect of the exemplary embodiment, which may be implemented in conjunction with the first or second aspect, the tip of the second elastic member may protrude with respect to the tip of the second core member.

This allows a clearance (Y3, Y4, Y5, Y6) to be left between the respective tips of the first core member and the second core member by specially designing the configuration of the second member.

In an electric device A1 according to a fourth aspect of the exemplary embodiment, which may be implemented in conjunction with the second aspect, the tip of the first elastic member may include a first stepped portion (stepped portion 112a), of which an outer portion has a greater protrusion length than an inner portion thereof.

This further reduces the exterior gap between the respective constituent members by making the tip of the first elastic member more easily flexible locally.

In an electric device A1 according to a fifth aspect of the exemplary embodiment, which may be implemented in conjunction with the third aspect, the tip of the second elastic member may include a second stepped portion (stepped portion 162a), of which an outer portion has a greater protrusion length than an inner portion thereof.

This further reduces the exterior gap between the respective constituent members by making the tip of the second elastic member more easily flexible locally.

Although the present invention has been described with reference to exemplary embodiments, those embodiments should not be construed as limiting but numerous modifications or variations can be readily made by those skilled in the art depending on their design choice or any other factor without departing from the true spirit and scope of the invention as defined by the appended claims.

### Reference Signs List

- A1: Electric Device
- 1: Housing
- 11: Case Body (First Member)
- 11a: Core Member
- 11b: Elastic Member (First Elastic Member)
- 11d: Sidewall (First Core Member)
- 12: Front Cover
- 14: Rear Cover
- 15: Cover Body (Second Member)
- 15a: Core Member
- 15b: Elastic Member (Second Elastic Member)
- 15e: Magnet Housing
- 15f: Peripheral Wall (Second Core Member)
- 15k: Opening Edge
- 16: Battery Lid (Second Member)
- 16a: Core Member
- 16b: Elastic Member (Second Elastic Member)
- 16d: Peripheral Wall (Second Core Member)
- 6: Magnet Unit
- 6a: Yoke
- 6b: Magnet
- 6c: Magnet Cap
- 66: Tip
- 2: Main Board
- 3: Sensor Unit
- 4: Mirror
- 5: Image Capturing Unit
- B1: Holder
- 71: Connecting Portion
- 72: Base
- 9: Recess
- 100: Structural Surface
- 110: First Wall Portion
- 150: Second Wall Portion
- 160: Second Wall Portion

## Claims

1. An electric device comprising: a first member including a first wall portion in a plate shape; and a second member including a second wall portion in a plate shape, the first wall portion and the second wall portion constituting a housing with their respective tips butted against each other,
the first wall portion being made up of a first core member and a first elastic member provided on an outer surface of the first core member, the second wall portion being made up of a second core member and a second elastic member provided on an outer surface of the second core member,
a clearance being provided between respective tips of the first core member and the second core member with respective tips of the first elastic member and the second elastic member butted against each other.

2. The electric device of claim 1, wherein
the tip of the first elastic member protrudes with respect to the tip of the first core member.

3. The electric device of claim 1 or 2, wherein
the tip of the second elastic member protrudes with respect to the tip of the second core member.

4. The electric device of claim 2, wherein
the tip of the first elastic member includes a first stepped portion, of which an outer portion has a greater protrusion length than an inner portion thereof.

5. The electric device of claim 3, wherein
the tip of the second elastic member includes a second stepped portion, of which an outer portion has a greater protrusion length than an inner portion thereof.
